**Europäisches Patentamt**

**European Patent Office**

**Office européen des brevets**

(11) Publication number: **0 201 102**
**B1**

(12) **EUROPEAN PATENT SPECIFICATION**

(45) Date of publication of patent specification: **29.08.90**

(21) Application number: **86106304.8**

(22) Date of filing: **07.05.86**

(51) Int. Cl.⁵: **C 08 F 220/12, C 09 J 133/04, C 09 J 7/02**

(54) Acrylic copolymer composition and adhesive coatings therefrom.

(30) Priority: **10.05.85 US 732787**

(43) Date of publication of application:
**12.11.86 Bulletin 86/46**

(45) Publication of the grant of the patent:
**29.08.90 Bulletin 90/35**

(84) Designated Contracting States:
**DE FR GB**

(56) References cited:
**GB-A-2 123 010**
**US-A-3 336 149**
**US-A-4 098 952**

(73) Proprietor: **E.I. DU PONT DE NEMOURS AND COMPANY**
**1007 Market Street**
**Wilmington Delaware 19898 (US)**

(72) Inventor: **Fryd, Michael**
**49 Warwick Road**
**Haddonfield, NJ 08033 (US)**
Inventor: **Pye, Walter E.**
**3211 Drexel Drive**
**Wilmington, DE 19810 (US)**
Inventor: **Redfearn, Richard Daniel**
**1104 Kings Highway**
**Haddon Heights, NJ 08035 (US)**

(74) Representative: **Werner, Hans-Karsten, Dr. et al**
**Deichmannhaus am Hauptbahnhof**
**D-5000 Köln 1 (DE)**

Courier Press, Leamington Spa, England.

## Description

### Field of invention

The invention relates to acrylic latex copolymer compositions and to adhesive coatings made therefrom.

### Background of the invention

The flexible circuit industry requires adhesives for polyimide film and copper which can withstand elevated temperatures and a variety of harsh solvents and chemicals. During the many preparation and processing steps for circuit manufacture, these solvents and chemicals can cause an adhesive to swell. This swelling leads to blister formation and/or delamination, which results in reduced circuit yields. The application of heat, such as in soldering, can similarly cause circuit failures. In preparing multilayer flexible circuits, manufacturers need adhesive-coated polyimide films which can effectively encapsulate patterned metal circuits and also provide a planar surface for subsequent lamination.

### Prior art

Crosslinkable acrylic adhesive compositions which bond to caustic treated polyimide elements are known from U.S. 3,822,175; 3,900,662 and 3,728,150. U.S. 3,336,149 and 3,418,392 disclose acrylic adhesive compositions which can be cured for bonding to textile fibers. Combinations of phenolic resins and acrylic copolymers for adhesive compositions are known from U.S. 4,435,543 and 3,376,279. A curable adhesive composition comprising 25 to 64.8% acrylate, 20 to 40% acrylonitrile and 0.2 to 5% glycidyl methacrylate is described in U.S. 4,404,324, whereas U.S. 4,098,952 describes 3 to 25% glycidyl methacrylate. Adhesive compositions incorporating acrylics and phenolic resins are described with different ranges of glass transition temperature in U.S. 3,758,634; 3,954,898; 4,132,916 and 4,378,450. Other uses of acrylic adhesives are described in U.S. 3,729,338; 3,787,520; 3,959,404; 4,042,645; 4,076,675 and 4,323,659.

The GB—A—2123010 discloses a process for flexibilizing epoxy resins. According to this invention an epoxy resin is flexibilized by addition, before hardening of the epoxy resin of 3—45% of an acrylate polymer which is obtainable among others by copolymerization of alkyl esters of acrylate and/or methacrylate, acrylonitrile, glycidyl acrylate and/or methacrylate. These copolymers, produced by conventional solution polymerization techniques, have a mean vapor pressure osmometry molecular weight of 1,000 to 3,000. The thus-modified epoxy resin can be used for bonding surfaces together.

In spite of the extensive work directed to curable adhesive compositions containing acrylic copolymers and phenolic resins, a need still exists for such adhesives having improved encapsulation and flow properties as well as chemical and thermal stability.

### Brief description of the invention

The invention is directed in one aspect to a latex copolymer prepared by free radial-initiated aqueous emulsion polymerization of a mixture of nonacidic monomers comprising 50—60 wt. % lower alkyl acrylate, 30—40 wt. % acrylonitrile, methacrylonitrile or mixtures thereof, and 5—12 wt. % glycidyl acrylate, glycidyl methacrylate or mixtures thereof, having a glass transition temperature ($T_g$) of 0—55°C and a weight average molecular weight ($\overline{M}_w$) of 300,000—2,000,000.

In a second aspect, the invention is directed to an adhesive coating composition comprising

(a) 90—99 wt. % of the above-described latex copolymer and

(b) 10—1 wt. % of a water-soluble crosslinking agent.

In a third aspect, the invention is directed to an adhesive film prepared by (1) applying a layer of the above-described adhesive coating to a substrate, (2) drying the composition at a temperature below the crosslinking temperature of the crosslinking agent and (3) heating the dried layer above the crosslinking temperature of the crosslinking agent to effect crosslinking thereof.

### Detailed description of the invention

#### A. Latex Copolymer

As noted above, the latex copolymer component of the invention is prepared by free radical-initiated aqueous emulsion polymerization of a mixture of nonacidic monomers comprising 50—60 wt. % lower alkyl acrylate, 30—40 wt. % acrylonitrile, methacrylonitrile, or mixtures thereof, and 5—12 wt. % glycidyl acrylate, glycidyl methacrylate or mixtures thereof. The resulting copolymer must have a $T_g$ of 0—55°C and $\overline{M}_w$ of 300,000—2,000,000.

As used herein, the term "lower alkyl" means $C_{1-4}$ alkyl groups.

When it is desired to have a low flow (high viscosity) composition, it is preferred that $\overline{M}_w$ of the copolymer be 1,500,000—2,000,000. On the other hand, when it is desired to have a high flow (low viscosity) composition, it is preferred that $\overline{M}_w$ of the copolymer be 300,000—900,000. Such latex copolymers can be made by conventional latex polymerization techniques such as those disclosed by Sanderson in U.S. 3,032,521.

A preferred low flow copolymer is a latex copolymer of 35/55/10 by weight acrylonitrile/butyl acrylate/glycidyl methacrylate having a $T_g$ of 40°C and $\overline{M}_{sw}$ of 1,600,000. A preferred high flow copolymer is one of the same monomer composition, the $\overline{M}_w$ of which is only 850,000.

#### B. Crosslinking Agent

The above-described latex copolymers are used in conjunction with 1—10% wt. of a water-soluble crosslinking agent such as melamine formaldehyde, phenol formaldehyde, urea formaldehyde. These crosslinkers are present in an amount of about 1—10% by weight of terpolymer. A polyvinyl alcohol thickener can be used to vary viscosity.

The composition may contain surface tension and viscosity control agents as well as fillers, colorants and flame retardant additives. In particular, 95% latex copolymer is combined with 5% phenol formaldehyde resin to provide a preferred adhesive composition to which about 0.5% by weight polyvinyl alcohol of molecular weight above 100,000 is added as a thickener. Other compatible thickening agents can be employed to facilitate film formation prior to drying.

C. Dispersing Medium

In most instances, it will be preferred to use the aqueous phase of the copolymer latex as the dispersing medium for the adhesive composition of the invention. However, if desired, the acrylic adhesive can be contained as a dispersion or dissolved in a suitable organic liquid or mixtures of organic liquids. Examples of these are aromatic hydrocarbons such as toluene and xylene; aliphatic hydrocarbons such as hexane and octane; esters such as ethyl acetate; ketones such as methyl ethyl ketone and methylisobutyl ketone; and ethers such as monoalkylethers of ethylene glycol. Examples of suitable organic liquids are disclosed in U.S. 3,032,521.

D. Formulation and Application

The adhesive composition can be prepared in an unsupported form by application to a release substrate such as coated paper or application onto polyimide films and/or metal sheets. Polyimides suitable for use as substrates in this invention are disclosed in Edwards U.S. 3,179,634.

The polyimide or other substrate may contain reinforcing and/or filler material, for example natural or synthetic fibers such as fiberglass, boron, polyester, polyamide, acrylic, Nomex® and Kevlar®, aromatic polyamides, nylon. Woven or nonwoven fabrics made from natural or synthetic fibers such as those mentioned above can also be used. Particular filler materials include silica, silicates, carbon black, carbonates, metals and metal oxides, such as magnesium oxide, calcium oxide, aluminum oxides. The composition may also contain flame retardant materials, such as antimony oxides and/or brominated or chlorinated phosphates, for example, tris-(2,3-dibromopropyl) phosphate.

The acrylic adhesive composition can be applied to the substrate film by conventional application procedures such as spraying, drying, printing, brushing, extrusion, dip coating, roll coating. If desired the acrylic adhesive can contain reinforcing and/or extender material such as those primarily enumerated as being suitable for the polyimide film.

In particular the adhesive composition can be applied to Kapton® polyimide film or used as a bonding medium between Kapton® polyimide film and copper. The adhesive composition can be stored in roll form using coated paper or Mylar® film.

The acrylic adhesive can be applied to the polyimide film or other substrate in varying thickness depending on the desired end use.

The acrylic adhesive-coated polyimide films can be adhered to suitable substrates to form laminates. Suitable substrates include metal and especially metal foils of copper, copper alloys, silver, silver alloys, gold, gold alloys; woven and nonwoven fabrics made from natural or synthetic fibers such as glass, boron, polyester, polyamide, acrylic; woven and nonwoven fabric impregnated with resin such as polyimide, polyamide, epoxy, acrylic; paper of natural or synthetic fibers such as Nomex® nylon paper; and film of polymer such as polyimide, polyamide, polyester, acrylic, epoxy, polyurethane. Preferred substrates include metal and especially copper, polyimide film, polyamide paper, woven and nonwoven glass fabric, and polyimide or epoxy impregnated glass fabric.

Various techniques can be used to join material surfaces using the adhesive films of the invention. For example when the film has been applied to a release support such as Mylar® polyester film or polymer coated paper, two materials can be joined by applying the exposed layer of the adhesive film to one of the materials, peeling off the substrate support from the adhesive film, thus exposing a second surface of the adhesive, and then laminating the second layer of material to the exposed surface of the adhesive film under pressure and heat sufficient to effect crosslinking of the crosslinking agent in the adhesive film.

On the other hand when the adhesive film is applied to a nonrelease support, e.g., a polyimide film the polyimide film can be joined to a second material such as a printed circuit board by laminating the polyimide-coated adhesive film to the second material under heat and pressure sufficient to initiate and effect complete crosslinking of the crosslinking agent.

Standard lamination procedures can be used to make the laminates such as vacuum bag lamination, press lamination, roll lamination. The laminates are useful as circuit boards, structural members.

In the examples, the method used for determining the weight average molecular weight ($\bar{M}_w$) is gel permeation chromatography. The analytical procedure consisted of dissolving 0.1—0.3% wt. polymer in tetrahydrofuran (THF) and chromatographing a sample on a micro Styragel® column versus a polymethylmethacrylate (PMMA) standard having a $\bar{M}_w$ of 100,000.

Example 1
(Low Flow Terpolymer)

In a 2 liter flask equipped with a mechanical stirrer, condenser, two addition funnels, a thermometer and nitrogen inlet were placed 380 g of deionized water, 16.4 g of acrylonitrile, 28.2 g of butyl acrylate, 2.3 g of glycidyl methacrylate and 0.01 g of ferric ammonium sulfate. This mixture was heated with stirring under a nitrogen atmosphere. When the temperature reached 75°C an initiator solution of 0.02 g of sodium metabisulfite, and 0.09 g of ammonium persulfate in 14.8 g of deionized water was added to the flask. The reaction mixture turned almost instantly into a blue-white emulsion. Immediately after addition of the initiator solution, two separate feeds were begun simultaneously. The first, a monomer feed consisting of a mixture of 147.9 g of acrylonitrile, 253.5 g of butyl acrylate and 21.1 g of glycidyl methacrylate was added to the reaction mixture over 140 minutes. The second, an initiator and surfactant feed, consisting of 0.1 g of sodium metabisulfite, 0.4 g of ammonium persulfate, 1.17 g of sodium lauryl sulfate and 20.8 g of deionized water, was added over 70 minutes. When the initial initiator and surfactant feed was finished, an identical second feed was added over an additional 70 minutes. The reaction during the feeds was exothermic and the temperature was maintained between 82 and 87°C. When the additions were finished, the monomer and initiator feed funnels were rinsed with 22.3 g and 9.4 g of deionized water respectively, and the rinses were added to the reaction mixture which was maintained at 80°C for an additional 2-1/2 hours. At the end of that time, the heat was shut off, the flask was cooled with a water bath and the reaction mixture, which was a blue-white emulsion, was filtered through felt to remove traces of coagulum. The emulsion had a viscosity of 0.04 Pas (40 centipoises) and 48.3% solids which corresponds to a 96.6% conversion. The terpolymer had a molecular weight ($\overline{M}_w$) of about 1,600,000 and $T_g$ of 40°C. In this and the following examples, viscosity was measured using a Brookfield LVF viscometer, No. 1 spindle at 12 $\min^{-1}$ (rpm) at room temperature.

A 2 mil (51 µm) Kapton® polyimide film was coated on one side with a 45 wt. % dispersion in water of an acrylic adhesive composition. The acrylic adhesive is a mixture of a terpolymer and crosslinking resin. The terpolymer is the reaction product of 35 wt. % acrylonitrile, 60 wt. % butyl acrylate and 5 wt. % glycidyl methacrylate with a molecular weight of approximately 1,600,000, and a $T_g$ of 40°C. To 86.2 g of terpolymer dispersion was added 2.4 g of an aqueous phenol formaldehyde resin solution (66% solids) and 8.2 g of an aqueous polyvinyl alcohol solution (4.2% solids). In this and the following examples the polyvinyl alcohol was Elvanol® 85—80.

Using a No. 36 wire-wound rod the acrylic composition was coated and dried at 120°C for 5 minutes. After drying, the adhesive coating was 1.0 mil (25.4 µm) thick and tack free.

Example 2
(Low Flow Terpolymer)

In a 2 liter flask equipped with a mechanical stirrer, condenser, two addition funnels, a thermometer and nitrogen inlet were placed 380 g of deionized water, 16.4 g of acrylonitrile, 25.8 g of butyl acrylate, 4.7 g of glycidyl methacrylate and 0.01 g of ferric ammonium sulfate. This mixture was heated with stirring under a nitrogen atmosphere. When the temperature reached 73°C, an initiator solution of 0.02 g of sodium metabisulfite

and 0.09 g of ammonium persulfate in 14.8 g of deionized water was added to the flask. The reaction mixture turned almost instantly into a blue-white emulsion. Right after the addition of the initiator solution, two separate feeds were begun simultaneously. The first, a monomer feed consisting of a mixture of 147.9 g of acrylonitrile, 232.4 g of butyl acrylate and 42.2 g of glycidyl methacrylate was added to the reaction mixture over 140 minutes. The second, an initiator and surfactant feed, consisted of 0.1 g of sodium metabisulfite, 0.4 g of ammonium persulfate, 1.17 g of sodium lauryl sulfate, and 20.8 g of deionized water and was added over 70 minutes. When the first initiator and surfactant feed was finished a second identical feed was added over an additional 70 minutes. The reaction during the feeds was exothermic and the temperature was maintained between 80 and 83°C. When the additions were finished, the monomer and initiator feed funnels were rinsed with 22.3 g and 9.4 g of deionized water respectively, and the rinses were added to the reaction mixture which was maintained at 82°C for an additional two hours. At the end of that time, the heat was shut off, the flask was cooled with a water bath, and the reaction mixture, which was a blue-white emulsion, was filtered through felt to remove traces of coagulum. The emulsion had a viscosity of 0.045 Pas (45 cps) and 48.5% solids which corresponds to 97% conversion.

A 2 mil (51 µm) Kapton® polyimide film was coated on one side with a 45 wt. % dispersion in water of an acrylic adhesive composition. The acrylic adhesive was a mixture of terpolymer and crosslinking resin. The terpolymer was the reaction product of 35 wt. % acrylonitrile, 55 wt. % butyl acrylate and 10 wt. % glycidyl methacrylate having a molecular weight of approximately 1,600,000 and a $T_g$ of 40°C. To 90.0 g of the terpolymer dispersion was added 3.5 g of an aqueous phenol formaldehyde resin solution (66% solids) and 9.0 g of an aqueous polyvinyl alcohol solution (4.2% solids).

Using a No. 36 wire-wound rod the acrylic composition was coated and dried at 120°C for 5 minutes. After drying, the adhesive coating was 1.0 mil (25.4 µm) thick and tack free.

Example 3
(High Flow Terpolymer)

In a 5 liter flask, equipped with a mechanical stirrer, condenser, two addition funnels, a thermometer and nitrogen inlet were placed 1900 g of deionized water, 82 g of acrylonitrile, 129 g of butyl acrylate, 24 g of glycidyl methacrylate and 0.05 g of ferric ammonium sulfate. This mixture was heated with stirring under a nitrogen atmosphere. When the temperature reached 75°C, an initiator solution of 0.1 g sodium metabisulfite and 4.5 g of ammonium persulfate in 74 g of deionized water was added to the flask. The reaction mixture turned milky. Right after the addition of the initiator solution, two separate feeds were begun simultaneously. The first, a monomer and chain transfer feed consisting of a mixture of 739 g of acrylonitrile, 1162 g of butyl acrylate, 211 g of glycidyl methacrylate and 20 g of dodecyl mercaptan was added to the reaction mixture over 140 minutes. The second, an initiator and surfactant feed, consisted of 0.5 g of sodium metabisulfite, 2 g of ammonium persulfate, 20 g of sodium lauryl sulfate and 104 g of deionized water, and was added over 70 minutes. When the first initiator and surfactant feed was finished, an identical second feed was added over an additional 70 minutes. The reaction during the feeds was exothermic and maintained itself without external heat between 83 and 91°C. When the additions were finished, the monomer and initiator feed funnels were rinsed with 158 g of deionized water, and the rinses were added to the reaction mixture which was heated at 85°C for an additional 2 hours. At the end of that time, the heat was shut off, the flask was cooled with a cold water bath, and the reaction mixture, which was a blue-white emulsion, was filtered through felt to remove traces of coagulum. The emulsion had a viscosity of 0.023 Pas (23 centipoises) and 48.2% solids which corresponds to 96.4% conversion. The terpolymer had a molecular weight ($\overline{M}_w$) of about 850,000 and a $T_g$ of 40°C.

A 2 mil (51 μm) Kapton® polyimide film was coated on one side with a 45 wt. % dispersion in water of acrylic adhesive composition. The acrylic adhesive was a mixture of a terpolymer and crosslinking resin. The terpolymer was the reaction product of 35 wt. % acrylonitrile, 55 wt. % butyl acrylate and 10 wt. % glycidyl methacrylate with a molecular weight of approximately 850,000 and a $T_g$ of 40°C. To 90.0 g of the terpolymer dispersion was added 3.5 g of an aqueous phenol formaldehyde resin solution (66% solids) and 9.0 g of an aqueous polyvinyl alcohol solution (4.2% solids).

Using a No. 36 wire-wound rod the acrylic composition was coated and dried at 120°C for 5 minutes. After drying, the adhesive coating was 1.0 mil (25.4 μm) thick and tack free.

## Example 4
(Prior Art Composition BA/AN/MAA 60/35/5)

Same as Example 1, except that methacrylic acid was used in place of glycidyl methacrylate. This material did not exhibit the improved chemical and thermal stability of the present invention when used to prepare polyimide laminates.

## Example 5
(Prior Art Composition BA/AN/MAA 60/35/5)

Same as Example 3, except that 5% methacrylic acid was substituted for 10% glycidyl methacrylate. This material exhibited improved encapsulation and flow, but had significantly reduced chemical and thermal stability.

## Example 6

A 45% solids by weight acrylic adhesive composition was prepared from the terpolymer dispersion of Example 2.

(1) To 86.2 g of dispersion 2 was added with stirring 2.4 g of an aqueous phenol formaldehyde resin solution (66% solids) and 8.2 g of an aqueous polyvinyl alcohol solution (4.2% solids).

(2) A portion of the resulting acrylic adhesive mixture from step (1) was coated on a 2.0 mil (51 μm) thick sheet of Kapton® polyimide film using a No. 36 wire-wound rod and then dried at 120°C for 5 minutes. After drying, the adhesive coating was about 1.0 mil (2.45 μm) thick and tack free.

(3) The adhesive coating of (2) was overlaid with a 36 μm thick sheet of rolled-annealed treated copper and press laminated at 350°F (177°C) and 250 psi (17.6 kg/cm$^2$) for 60 minutes.

This produced a copper clad laminate having an adhesive strength of copper to Kapton® film of 12 lbs/in (2.1 kg/cm) and an adhesive flow during lamination of 3 mils (76 μm). This was sufficient to encapsulate etched copper lines but low enough not to flow into pre-drilled holes in the circuit board. This laminate was floated on a solder bath at 600°F (316°C) for 5 minutes without blistering. After copper removal by chemical etching (aqueous ammonium persulfate/sulfuric acid), the exposed adhesive was resistant to alkaline semi-aqueous stripper (1 part J&S 732 to 3 parts water) for over 10 minutes at 150°F (68°C) without blistering or delamination.

## Example 7

A 45% solids by weight acrylic adhesive composition was prepared from the terpolymer dispersion of Example 3.

(1) To 90.0 g of dispersion 3 was added with stirring 3.5 g of an aqueous phenol formaldehyde resin solution (66% solids) and 9.0 g of an aqueous polyvinyl alcohol solution (4.2% solids).

(2) A portion of the resulting acrylic adhesive mixture from step (1) was coated on a 2.0 mil (51 μm) thick sheet of Kapton® polyimide film using a No. 36 wire-wound rod and then dried at 120°C for 5 minutes. After drying, the adhesive coating was about 1.0 mil (25.4 μm) thick and tack free.

(3) The adhesive coating of (2) was overlaid with a 36 μm thick sheet of rolled-annealed treated copper and press laminated at 350°F (177°C), 250 psi (17.6 kg/cm$^2$) for 60 minutes.

This produced a copper clad laminate having an adhesive strength of copper to Kapton® film of 11.5 lbs/in (2.1 kg/cm) and an adhesive flow during lamination of 18 mil (457 μm), which is sufficient to completely encapsulate the inner layers of a printed circuit without excessive resin overflow. This laminate was floated on a solder bath at 600°F (316°C) for 5 minutes without blistering or delamination. After copper removal by chemical etching (aqueous ammonium persulfate/sulfuric acid), the exposed adhesive was resistant to alkaline semi-aqueous resist stripper (1 part J&S 732 to 3 parts water) for 10 minutes at 150°F (68°C) without blistering or delamination.

## Example 8

A 45% solids by weight acrylic adhesive composition was prepared from the terpolymer dispersion of Example 3.

(1) To 90.0 g of dispersion 3 was added with stirring 3.5 g of an aqueous phenol formaldehyde resin solution (66% solids).

(2) A portion of the resulting acrylic adhesive mixture from step (1) was used to impregnate by dip coating a 2.3 mil (58.4 μm) thick sheet of Nomex® aramid fabric and then dried at 120°C for 5 minutes. After drying, the Nomex® reinforced adhesive composition was about 3.7 mil (94 μm) thick and tack free.

(3) The Nomex® reinforced adhesive composite of (2) was overlaid with a 36 μm sheet of rolled-annealed treated copper and press laminated at 350°F (177°C), 250 psi (17.6 kg/cm) for 60 minutes.

This produced a copper clad laminate having an adhesive strength of copper to Nomex® of 10.5 lbs/in (1.9 kg/cm). This laminate was floated on a solder bath at 600°F (316°C) for 30 sec. without blistering or delamination. After copper removal by chemical etching (aqueous ammonium persulfate/sulfuric acid), the exposed adhesive was resistant to alkaline semi-aqueous resist stripper (1 part Riston® S1100 X to 3 parts water) for 5 minutes at 130°F (54°C) without blistering or delamination.

Example 9

A 45% solids by weight acrylic adhesive composition was prepared from the terpolymer dispersion of Example 3.

(1) To 90.0 g of dispersion 3 was added with stirring 3.5 g of an aqueous phenol formaldehyde resin solution (66% solids).

(2) A portion of the resulting acrylic adhesive mixture from step (1) was used to impregnate by dip coating a 2.8 mil (71 μm) thick sheet of Kevlar® aramid fabric and then dried at 120°C for 5 minutes. After drying, the Kevlar® fiber-reinforced adhesive composition was about 4.2 mils (107 μm) thick and tack free.

(3) the Kevlar® fiber-reinforced adhesive composite of (2) was overlaid with a 36 μm sheet of rolled-annealed treated copper and press laminated at 360°F (182°C), 200 psi (14 kg/cm²) for 60 minutes.

This produced a copper clad laminate having an adhesive strength of copper to Kevlar® of 9.5 lbs/in (1.7 kg/cm). This laminate was floated on a solder bath at 550°F (287°C) for 5 min. without blistering or delamination. After copper removal by chemical etching (aqueous ammonium persulfate/sulfuric acid), the exposed adhesive was resistant to alkaline semi-aqueous resist stripper (1 part Riston® S1100 X to 3 parts water) for 5 minutes at 130°F (54°C) without blistering or delamination.

Glossary of Tradenames

The following are tradenames of E. I. du Pont de Nemours and Company, Inc., Wilmington, Delaware for the indicated materials.

Elvanol®    Polyvinyl alcohol
Kapton®    Polyimide film
Kevlar®    Aramid fiber
Mylar®    Polyester film
Nomex®    Aramid fiber and sheet material
Riston®    Photopolymer resist equipment and stripping agents.

Styragel® is a tradename of Water's Associates, Milford, MA for polystyrene-based chromatographic separation materials.

J&S 732 is a tradename of J&S Laboratories, Los Angeles, CA for alkaline aqueous glycol ether/alkanolamine mixtures.

**Claims**

1. A latex copolymer prepared by free radical-initiated aqueous emulsion polymerization of a mixture of nonacidic monomers comprising 50—60 wt. % lower alkyl acrylate, 30—40 wt. % acrylonitrile, methacrylonitrile or mixtures thereof, and 5—12 wt. % glycidyl acrylate, glycidyl methacrylate or mixtures thereof, having a $T_g$ of 0—55°C and a weight average molecular weight of 300,000—2,000,000.

2. An adhesive coating composition comprising
(a) 90—99% wt. of the latex copolymer of claim 1 having dissolved in the aqueous phase;
(b) 10—1% wt. of a crosslinking agent.

3. The coating composition of claim 2 in which the copolymer $\overline{M}_w$ is 1,500,000—2,000,000.

4. The coating composition of claim 2 in which the copolymer $\overline{M}_w$ is 300,000—9000.000.

5. The coating composition of claim 2 in which the crosslinking agent is a phenol formaldehyde resin.

6. A method for forming a supported adhesive film comprising
a. applying to a surface of a substrate a continuous thin layer of the adhesive coating composition of claim 2; and
b. drying the layer without incurring crosslinking of the crosslinking agent.

7. The method of claim 6 in which the substrate is a release substrate.

8. The method of claim 6 in which the substrate is a nonrelease substrate.

9. The method of claim 8 in which the substrate is a polyimide film.

10. The method of claim 8 in which the nonrelease substrate is a fabric of aramid fiber.

11. A method for joining two material layers comprising the steps of
(a) applying to the first of the two material layers an adhesive film made by the method of claim 7;
(b) separating the substrate from the applied adhesive film;
(c) applying to the exposed surface of the adhesive film the second material layer and
(d) subjecting the assemblage of steps (a) through (c) to pressure and heat to crosslink the crosslinking agent.

12. The method of claim 11 in which the second material layer is a fabric of aramid fiber.

13. The method of claim 11 in which both material layers are metal foils.

14. A method for joining a material layer with a supported film made by the method of claim 8; comprising the steps of

(a) applying to the exposed surface of the supported adhesive film the material layer and

(b) subjecting the assemblage to pressure and heat to crosslink the crosslinking agent.

15. The method of claim 14 in which the support of the supported adhesive film is a polyimide film and the material layer is a flexible metal foil.

16. The method of claim 15 in which the foil metal is copper.

## Patentansprüche

1. Latex-Copolymer, hergestellt durch Polymerisation, die durch freie Radikale eingeleitet wird, in wäßriger Emulsion nicht-saurer Monomere, umfassend 50—60 Gew.-% Niederalkylacrylat, 30 bis 40 Gew.-% Acrylnitril, Methacrylnitril oder von deren Mischungen und 5 bis 12 Gew.-% Glycidylacrylat, Glycidylmethacrylat oder von deren Mischungen, mit einem $T_g$ von 0°C bis 55°C und einem Gewichtsmittel des Molekulargewichts von 300 000 bis 2 000 000.

2. Haftmittel-Beschichtungs-Zusammensetzung, umfassend

(a) 90 bis 99 Gew.-% des Latex-Copolymers nach Anspruch 1, das, gelöst in der wäßrigen Phase,

(b) 10 bis 1 Gew.-% eines Vernetzungsmittels aufweist.

3. Haftmittel-Beschichtungs-Zusammensetzung nach Anspruch 2, worin das Copolymer-$\bar{M}_w$ 1 500 000 bis 2 000 000 beträgt.

4. Haftmittel-Beschichtungs-Zusammensetzung nach Anspruch 2, worin das Copolymer-$\bar{M}_w$ 300 000 bis 900 000 beträgt.

5. Haftmittel-Beschichtungs-Zusammensetzung nach Anspruch 2, worin das Vernetzungsmittel ein Phenol-Formaldehyd-Harz ist.

6. Verfahren zu Bildung eines trägerunterstützten Haftmittel-Films, umfassend

a. das Aufbringen einer dünnen Schicht der Haftmittel-Beschichtungs-Zusammensetzung nach Anspruch 2 auf eine Oberfläche eines Substrats und

b. das Trocknen der Schicht, ohne eine Vernetzung durch das Vernetzungsmittel herbeizuführen.

7. Verfahren nach Anspruch 6, worin das Substrat ein Trennsubstrat ist.

8. Verfahren nach Anspruch 6, worin das Substrat ein Nicht-Trennsubstrat ist.

9. Verfahren nach Anspruch 8, worin das Substrat eine Polyimid-Folie ist.

10. Verfahren nach Anspruch 8, worin das Nicht-Trennsubstrat ein Textilgebilde aus Aramid-Faser ist.

11. Verfahren zum Verbinden zweier Material-Schichten, umfassend die Schritte

(a) des Aufbringens eines mittels des Verfahrens nach Anspruch 7 hergestellten Haftmittel-Films auf die erste der zwei Material-Schichten;

(b) des Trennens des Substrats von dem aufgebrachten Haftmittel-Film;

(c) des Aufbringens der zweiten Material-Schicht auf die freigelegte Oberfläche des Haftmittel-Films und

(d) das Einwirkenlassen von Druck und Wärme auf das nach den Schritten (a) bis (c) erhaltene Gebilde, um das Vernetzungsmittel zu vernetzen.

12. Verfahren nach Anspruch 11, worin die zweite Material-Schicht ein Textilgebilde aus Aramid-Faser ist.

13. Verfahren nach Anspruch 11, worin beide Material-Schichten Metall-Folien sind.

14. Verfahren zum Verbinden einer Material-Schicht mit einem mittels des Verfahrens nach Anspruch 8 hergestellten trägerunterstützten Films, umfassend die Schritte

(a) des Aufbringens der Material-Schicht auf die freigelegte Oberfläche des trägerunterstützten Haftmittel-Films und

(b) das Einwirkenlassen von Druck und Wärme auf das erhaltene Gebilde, um das Vernetzungsmittel zu vernetzen.

15. Verfahren nach Anspruch 14, worin der Träger des trägerunterstützten Haftmittel-Films eine Polyimid-Folie ist und die Material-Schicht eine biegsame Metall-Folie ist.

16. Verfahren nach Anspruch 15, worin die Metall-Folie aus Kupfer ist.

## Revendications

1. Un copolymère en latex préparé par polymérisation en émulsion aqueuse, amorcée par des radicaux libres, d'un mélange de monomères non acides comprenant 50 à 60% en poids d'acrylate d'alkyle inférieur, 30 à 40% en poids d'acrylonitrile, de méthacrylonitrile ou de mélanges d'entre eux, et 5 à 12% en poids d'acrylate de glycidyle, de méthacrylate de glycidyle ou de mélanges d'entre eux, ayant une $T_v$ de 0 à 55°C et un poids moléculaire moyen en poids de 300 000 à 2 000 000.

2. Une composition d'enduit adhésif comprenant

(a) 90 à 99% en poids du copolymère en latex de la revendication 1 dont la phase aqueuse contient, à l'état dissous:

(b) 10 à 1% en poids d'un agent de réticulation.

3. La composition d'enduit de la revendication 2, dans laquelle le $\bar{M}_p$ du copolymère est de 1 500 000 à 2 000 000.

4. La composition d'enduit de la revendication 2, dans laquelle le $\bar{M}_p$ du copolymère est de 300 000 à 900 000.

5. La composition d'enduit de la revendication 2, dans laquelle l'agent de réticulation est une résine phénol-formaldéhyde.

6. Un procédé pour former une pellicule d'adhésif supportée, consistant à

a. appliquer à une surface d'un substrat une couche mince continue de la composition d'enduit adhésif de la revendication 2; et

b. sécher la couche sans entraîner le réticulation de l'agent de réticulation.

7. Le procédé de la revendication 6, dans lequel le substrat est un substrate détachable.

8. Le procédé de la revendication 6, dans lequel le substrat est un substrat non détachable.

9. Le procédé de la revendication 8, dans lequel le substrat est une pellicule de polyimide.

10. Le procédé de la revendication 8, dans lequel le substrat non détachable est un tissu de fibre d'aramide.

11. Un procédé pour assembler deux couches de matériaux, comprenant les étapes suivantes

(a) appliquer une pellicule d'adhésif formée par le procédé de la revendication 7 à la première des deux couches de matériaux;

(b) séparer le substrat de la pellicule d'adhésif appliquée;

(c) appliquer la seconde couche de matériau à la surface exposée de la pellicule d'adhésif; et

(d) soumettre l'assemblage des étapes (a) à (c) à des conditions de chaleur et pression pour réticuler l'agent de réticulation.

12. Le procédé de la revendication 11, dans lequel la seconde couche de matériau est un tissu de fibre d'aramide.

13. Le procédé de la revendication 11, dans lequel les deux couches de matériaux sont des feuilles métalliques.

14. Un procédé pour assembler une couche de matériau avec une pellicule d'adhésif supportée formée par le procédé de la revendication 8, comprenant les étapes suivantes

(a) appliquer la couche de matériau à la surface exposée de la pellicule d'adhésif supportée; et

(b) soumettre l'assemblage à des conditions de chaleur et pression pour réticuler l'agent de réticulation.

15. Le procédé de la revendication 14, dans lequel le support de la pellicule d'adhésif supportée est une pellicule de polyimide et la couche de matériau est une feuille métallique souple.

16. Le procédé de la revendication 15, dans lequel le métal de la feuille est du cuivre.